# EUROPÄISCHE PATENTANMELDUNG

(11) **EP 4 823 277 A1**
(43) Veröffentlichungstag der Anmeldung: **14.10.2026**
(21) Anmeldenummer: 25169642.3
(22) Anmeldetag: 10.04.2025
(51) Int. Cl.: H10F 10/14, H10F 10/165, H10F 71/00, H10F 77/20

(54) **INTERDIGITATED BACK CONTACT SOLARZELLE UND VERFAHREN ZUR HERSTELLUNG EINER INTERDIGITATED BACK CONTACT SOLARZELLE**

(71) Anmelder: "International Solar Energy Research Center Konstanz", ISC Konstanz e.V., 78467 Konstanz (DE)
(72) Erfinder: Linke, Dr. Jonathan, 78467 Konstanz (DE); Buchholz, Dr. Florian, 78462 Konstanz (DE)
(74) Vertreter: Westphal, Mussgnug & Partner Patentanwälte mbB

(57) **Zusammenfassung**

Bereitgestellt werden eine Interdigitated Back Contact Solarzelle, mit einem ersten Dotierungstyp dotierten Silizium Wafer (100) mit einer Fronseite und einer Rückseite, einem auf der Rückseite angeordneten, mit einem zweiten Dotierungstyp dotierten Bereich mit einem Tunnelkontakt, der durch eine Tunneloxidschicht (200,300) und darüber liegende poly-Si Schicht (210,310) gebildet wird, einer auf der Rückseite angeordneten, mit dem ersten Dotierungstyp dotierten Bereich mit einem Tunnelkontakt, der durch eine Tunneloxidschicht (200,300) und darüber liegende poly-Si Schicht (210,310) gebildet wird, und einem zwischen dem mit dem ersten Dotierungstyp dotierten Bereich und dem mit dem zweiten Dotierungstyp dotierten Bereich liegenden, mit dem ersten oder zweiten Dotierungstyp dotierten Gap (40) ohne Tunnelkontakt,
**dadurch gekennzeichnet,** dass das Dotierungsprofil des Gaps (40) gleich dem Dotierungsprofil unterhalb der den Tunnelkontakt bildenden Tunneloxidschicht (200,300) des zum Gap (40) benachbarten mit dem gleichen Dotierungstyp dotierten Bereichs ist (30) sowie ein Verfahren zur Herstellung einer solchen interdigitated Back Contact Solarzelle.

## Beschreibung

Interdigitated Back Contact (IBC) Solarzellen, im Folgenden auch kurz als "IBC Solarzellen" bezeichnet, werden als solche bezeichnet, weil sich auf ihrer Rückseite ineinandergreifende p-dotierte Emitter und n-dotierte Basisbereiche befinden (daher "interdigitated"), was es erlaubt, ihre Kontakte lediglich auf der im Betrieb typischerweise von der Sonne abgewandten Rückseite einer solchen Solarzelle anzuordnen (daher "back contact") und so eine Abschattung durch Kontakte auf der Frontseite zu vermeiden, was die Ausbeute der Solarzelle verbessert.

Eine besonders effiziente Unterkategorie der Interdigitated Back Contact Solarzellen sind TOPCon Back Contact (TBC) Solarzellen. Wie durch den Namensbestandteil "TOPCon", der als Abkürzung für "Tunnel Oxide Passivating Contact" verwendet wird, signalisiert wird, sind bei diesen Solarzellen die Kontaktbereiche beider Polaritäten als poly-Si/SiOx basierte, passivierte Kontakte, beispielsweise im verbreiteten Fall der Realisierung auf einem n-Typ Siliziumwafer als p-dotierten Emitter mit Tunnelkontakt und als n-dotierte Basis mit Tunnelkontakt, ausgestaltet.

Solche Solarzellen sind hocheffizient, waren aber in ihrer Herstellung bis zur Einführung des polyZEBRA TBC Solarzellenkonzepts der Anmelderin prohibitiv teuer. Einen Überblick über dieses Solarzellenkonzept liefert der Artikel ">24% Efficient Tunnel Back Contacted Polyzebra Solar Cells" von J. Linke et al, EPJ Photovolt. 16 (8), 2025; DOI: /10.1051/epjpv/2024051. Eine Besonderheit des Konzepts besteht in der konsequenten Nutzung von Vorgehensweisen, die mit dem in der Solarzellproduktion bereits bewährten und demzufolge in den Produktionslinien schon vorhandenen Equipment realisierbar sind.

Ein nach wie vor problematischer Aspekt bei der Fertigung insbesondere der bekannten IBC Solarzellen vom polyZEBRA-TBC-Typ ist aber, dass bei diesem Typ ein p-dotiertes Gap zwischen p-dotiertem Emitter und n-dotierter Basis vorliegt. Die p-Dotierung in der Gap-Region ist deshalb kompliziert, weil eine möglichst niedrige Rekombinationsrate anzustreben ist, was es wünschenswert macht, dass sowohl die Oberflächenkonzentration als auch die Dotierprofil-Tiefe gering sind. Dies ist aber bei einer Bor-Diffusion schwierig zu erreichen, weil dabei der übliche Weg, um eine niedrige Oberflächenkonzentration von Bor zu erreichen ein Eintreiben des Bors ist, was aber gerade zu dem ebenfalls zu vermeidenden tiefen Dotierprofil führt. Eine bekannte Lösung kann darin bestehen, den Dotiergasfluss und die Temperatur herabzusetzen, was sich aber negativ auf die Homogenität über den Wafer und das Boot hinweg auswirkt.

Die Aufgabe der Erfindung besteht daher darin, eine IBC Solarzelle, die eine dotierte Gap-region mit verbesserter Rekombinationsrate aufweist bereitzustellen und ein Verfahren zur Herstellung einer solchen IBC Solarzelle bereitzustellen.

Diese Aufgabe wird gelöst durch eine IBC Solarzelle mit den Merkmalen des Patentanspruchs 1 und durch ein Verfahren zur Herstellung einer IBC Solarzelle mit den Merkmalen des Patentanspruchs 4. Vorteilhafte Weiterbildungen der Erfindung sind Gegenstand der jeweiligen abhängigen Patentansprüche.

Die erfindungsgemäße Interdigitated Back Contact Solarzelle hat einen mit einem ersten Dotierungstyp dotierten Silizium Wafer mit einer Fronseite und einer Rückseite, einen auf der Rückseite angeordneten, mit einem zweiten Dotierungstyp dotierten Bereich mit einem Tunnelkontakt, der durch eine Tunneloxidschicht und eine darüber liegende dotierte poly-Si Schicht gebildet wird, einen auf der Rückseite angeordneten, mit dem ersten Dotierungstyp dotierten Bereich mit einem Tunnelkontakt, der durch eine Tunneloxidschicht und eine darüber liegende dotierte poly-Si Schicht gebildet wird, und ein zwischen dem mit dem zweiten Dotierungstyp dotierten Bereich mit einem Tunnelkontakt und dem mit dem ersten Dotierungstyp dotierten Bereich mit einem Tunnelkontakt liegendes, mit dem zweiten oder mit dem ersten Dotierungstyp dotiertes Gap, das keinen Tunnelkontakt aufweist.

Ist also der erste Dotierungstyp eine n-Dotierung, und somit der Silizium Wafer n-dotiert, so ist der mit dem zweiten Dotierungstyp dotierte Bereich mit einem Tunnelkontakt p-dotiert und kann einen p-dotierten Emitter bilden, während der mit dem ersten Dotierungstyp dotierte Bereich dann n-dotiert ist und eine n-dotierte Basis bildet. Das keinen Tunnelkontakt aufweisende Gap zwischen dem p-dotierten Emitter und der n-dotierten Basis ist dann bevorzugt p-dotiert. Diese bevorzugte Konfiguration ist bei einer polyZEBRA TBC Solarzelle realisiert.

Erfindungswesentlich ist, dass das Dotierungsprofil des mit dem zweiten oder mit dem ersten Dotierungstyp dotierten Gaps gleich dem Dotierungsprofil unterhalb der den Tunnelkontakt bildenden Tunneloxidschicht des zum Gap benachbarten Bereichs mit demselben Dotierungstyp ist. Im Fall der oben beschriebenen Zuordnung der Dotierungstypen, wie sie bei der polyZEBRA TBC Solarzelle vorgenommen wird ist also das Gap p-dotiert und sein Dotierungsprofil gleich dem Dotierungsprofil unterhalb der den Tunnelkontakt bildenden Tunneloxidschicht des zum Gap benachbarten p-dotierten Emitters.

Die technische Bedeutung dieses Merkmals erschließt sich, wenn man bedenkt, dass dieser Abschnitt des Dotierungsprofils im Bereich des Tunnelkontakts, beispielsweise des p-dotierten Emitters, ein relativ tief liegender Abschnitt ist, in den die dort vorhandenen Dotierungsatome bei der Erwärmung lediglich mit eingetrieben werden, was zu der erwünschten niedrigen Oberflächenkonzentration der Dotierungsatome im Gap führt, ohne dass diese geringe Oberflächenkonzentration durch ein tiefes Dotierprofil, das während einer Diffusion durch Eintreiben erheblicher Mengen von Dotierungsatomen erzeugt wird, erkauft würde. Praktisch kann eine solche Gleichheit von Dotierungsprofilen insbesondere dann erreicht werden, wenn während des Dotiervorgangs eine identische Abfolge von Materialschichten im Bereich des entsprechenden Tunnelkontakts und im Gap vorhanden ist.

Die bevorzugte Herangehensweise ist, die erwünschte niedrige Oberflächenkonzentration ohne ein tiefes Dotierprofil der Dotierungsatome zu erreichen, indem im Gap während der Erwärmung zusätzliche Schichten vorhanden sind, die so dimensioniert sind, dass nur der Tail des Dotierungsprofils in den Bereich des Gaps hineinragt und der Rest des Dotierungsprofils mit diesen Schichten im Bereich des Gaps anschließend entfernt wird. Dementsprechend ist es besonders bevorzugt, wenn das dotierte Gap durch einen Teilbereich eines unterhalb der den Tunnelkontakt bildenden Tunneloxidschicht des zum Gap benachbarten gleich dotierten Bereichs mit Tunnelkontakt, beispielsweise bei einem p-dotierten Gap des p-dotierten Emitters, verlaufenden Tails gebildet wird, der sich ausgehend von diesem in Richtung auf einen benachbarten mit dem anderen Dotierungstyp dotierten Bereich -im Fall des p-dotierten Gaps und des p-dotierten Emitters also die n-dotierte Basis- mit Tunnelkontakt hin erstreckt. Dementsprechend ist nachfolgend unter dem Begriff "Tail" das eingetriebene Dotierprofil unterhalb des Tunneloxids zu verstehen.

Eine weitere Reduktion der Rekombinationsrate im Bereich des Gaps kann dadurch erreicht werden, dass die Oberfläche im Bereich des Gaps glatt und nicht texturiert ist. Dies wird beispielsweise durch das Aufbringen einer Schutzschicht ermöglicht.

Das bevorzugte Verfahren zur Herstellung einer solchen Interdigitated Back Contact Solarzelle zeichnet sich dadurch aus, dass die Ausbildung des Dotierprofils des dotierten Gaps und des benachbarten gleich dotierten Bereichs mit Tunnelkontakt gemeinsam erfolgt. Beispielsweise werden also bei einem n-dotierten Si-Wafer der p-dotierte Emitter mit Tunnelkontakt und das p-dotierte Gap gemeinsam dotiert. Dadurch wird ein zusätzlicher p-Dotierungsschritt vermieden. Dies lässt sich insbesondere dadurch erreichen, dass eine entsprechend dotierte Poly-Si-Schicht auf einem Tunneloxid hergestellt wird und so thermisch erhitzt wird, dass die Dotanten durch das Tunneloxid in den Wafer eingetrieben werden.

Dies kann beispielsweise bei einer gemeinsamen Dotierung des p-dotierten Emitters mit Tunnelkontakt und des p-dotierten Gaps durch einen Bor-Diffusionsprozess erfolgen. Wenn dieser thermische Schritt der einzige und/oder der letzte Hochtemperaturschritt bei der Herstellung der Interdigitated Back Contact Solarzelle ist, wird ein möglicher Eintrag von Verunreinigungen aus einer alkalischen Ätzlösung eines späteren Ätzschrittes durch das Poly-Si in den Wafer weitgehend unterdrückt.

Allgemein kann die Dotierung einer zuvor undotierten poly-Si-Schicht und das Eintreiben der Dotanten durch das Tunneloxid in den Wafer in einem Diffusionsprozess kombiniert werden, wenn der Bor-Diffusionsprozess eine Depositionsphase und eine Eintreibephase umfasst.

Um das gewünschte Dotierungsprofil im Bereich des Gaps zu erhalten ist eine besonders bevorzugte Herangehensweise, dass während der gemeinsam erfolgenden Dotierung des p-dotierten Emitters mit Tunnelkontakt und des p-dotierten Gaps die Tunneloxidschicht und die Poly-Si-Schicht, die zur Herstellung des p-dotierten Emitters mit Tunnelkontakt p-dotiert wird, den Bereich, in dem das p-dotierte Gap erzeugt wird mit überdecken und dass nach der gemeinsam erfolgenden Dotierung des p-dotierten Emitters mit Tunnelkontakt und des p-dotierten Gaps diese Schichten im Bereich des p-dotierten Gaps entfernt werden. Bevorzugt ist es dabei, wenn diese beiden Schichten in zwei separat voneinander verlaufenden Prozessschritten entfernt werden.

Eine bevorzugte Realisierung dieses Entfernens besteht darin, dass nach der gemeinsam erfolgenden Dotierung des dotierten Bereichs, beispielsweises eines p-dotierten Emitters, mit Tunnelkontakt und des gleichartig, beispielsweise p-dotierten, Gaps die elektrisch aktive Dotierkonzentration in der dotierten Poly-Si-Schicht im Bereich des dotierten Bereichs, also beispielsweise des p-dotierten Emitters mit Tunnelkontakt, durch Bestrahlung mit einem Laser erhöht und die Poly-Si-Schicht damit lokal -insbesondere in alkalischer Lösung- ätzstabil wird und danach im Bereich des dotierten Gaps zurückgeätzt wird. Durch den Wegfall eines nachfolgenden Hochtemperaturschrittes, insbesondere im Vergleich zum bekannten polyZEBRA Herstellungsprozess, bleibt die hohe elektrisch aktive Dotierkonzentration der dotierten Poly-Si-Schicht im Bereich des dotierten Bereichs, beispielsweise des p-dotierten Emitters, erhalten, was zu einem niedrigeren Schichtwiderstand und Kontaktwiderstand zu den Metallelektroden führt und somit die Effizienz der Solarzelle erhöht.

Um zu gewährleisten, dass der Ätzprozess den eindiffundierten Bereich unterhalb der Tunneloxidschicht im Bereich des dotierten Gaps nicht mit entfernt, ist unabhängig von der Dotierung des Gaps ein bevorzugter Ansatz, dass das Zurückätzen im Bereich des dotierten Gaps mit einer alkalischen Ätzlösung erfolgt, deren Ätzrate für Poly-Si höher ist als für das Tunneloxid, so dass es eine gewisse Zeit dauert die Tunneloxidschicht aufzulösen, während welcher der Ätzprozess beendet wird. Auf diese Weise wird ausschließlich die Poly-Si-Schicht entfernt. Ein Beispiel für eine derartige Ätzlösung ist TMAH (Tetramethylammoniumhydroxid) oder KOH (Kaliumhydroxid) mit entsprechendem Additiv. Das Zurückätzen kann aber auch durch andere Techniken wie beispielsweise atmospheric dry etching erfolgen. Die Tunneloxidschicht kann anschließend in einem Ätzschritt mit HF (Fluorwasserstoff) entfernt werden, so dass in der Gap Region ausschließlich der p-dotierte eindiffundierte Bereich mit niedriger Oberflächenkonzentration übrig bleibt. Im Vergleich zum Referenzprozess ist die Oberfläche in diesem Bereich glatt und nicht texturiert, was die Oberflächenrekombination weiter reduzieren kann.

Wenn in weiteren Prozessschritten die Frontseite der Solarzelle bearbeitet werden soll, wird zuvor, aber erst nach der Dotierung des p-dotierten Emitters mit Tunnelkontakt in einem weiteren Verfahrensschritt eine Schutzschicht auf die Rückseite der Solarzelle aufgebracht, die nach Ausführung der weiteren Prozessschritte an der Frontseite der Solarzelle wieder entfernt wird. Alternativ kann auch die Passivierungsschicht als Schutzschicht dienen, welche dann nicht wieder entfernt würde. Insbesondere kann nach dem Aufbringen der Schutzschicht auf die Rückseite der Solarzelle die Frontseite der Solarzelle texturiert werden. Ferner kann nach dem Aufbringen der Schutzschicht auf die Rückseite der Solarzelle die Frontseite n-dotiert werden, so dass ein Front Surface Field gebildet wird, sie kann jedoch auch p-dotiert (Floating Emitter) oder gar nicht dotiert werden.

Die Erfindung wird nachfolgend anhand von Figuren, die Ausführungsbeispiele zeigen, näher erläutert. Es zeigt:
- Fig. 1:: Ein Ausführungsbeispiel einer IBC polyZEBRA Solarzelle;
- Fig. 2a:: Ein erstes Zwischenstadium bei der Herstellung einer IBC Solarzelle;
- Fig. 2b:: ein zweites Zwischenstadium bei der Herstellung einer IBC Solarzelle;
- Fig. 2c:: ein drittes Zwischenstadium bei der Herstellung einer IBC Solarzelle;
- Fig. 2d:: ein viertes Zwischenstadium bei der Herstellung einer IBC Solarzelle;
- Fig. 2e:: ein fünftes Zwischenstadium bei der Herstellung einer IBC Solarzelle;
- Fig. 2f:: ein sechstes Zwischenstadium bei der Herstellung einer IBC Solarzelle;
- Fig. 2g:: ein siebtes Zwischenstadium bei der Herstellung einer IBC Solarzelle;
- Fig. 2h:: ein achtes Zwischenstadium bei der Herstellung einer IBC Solarzelle;
- Fig. 2i:: ein neuntes Zwischenstadium bei der Herstellung einer IBC Solarzelle;
- Fig. 2j:: ein zehntes Zwischenstadium bei der Herstellung einer IBC Solarzelle;
- Fig. 2k:: ein elftes Zwischenstadium bei der Herstellung einer IBC Solarzelle;
- Fig. 21:: ein zwölftes Zwischenstadium bei der Herstellung einer IBC Solarzelle; und

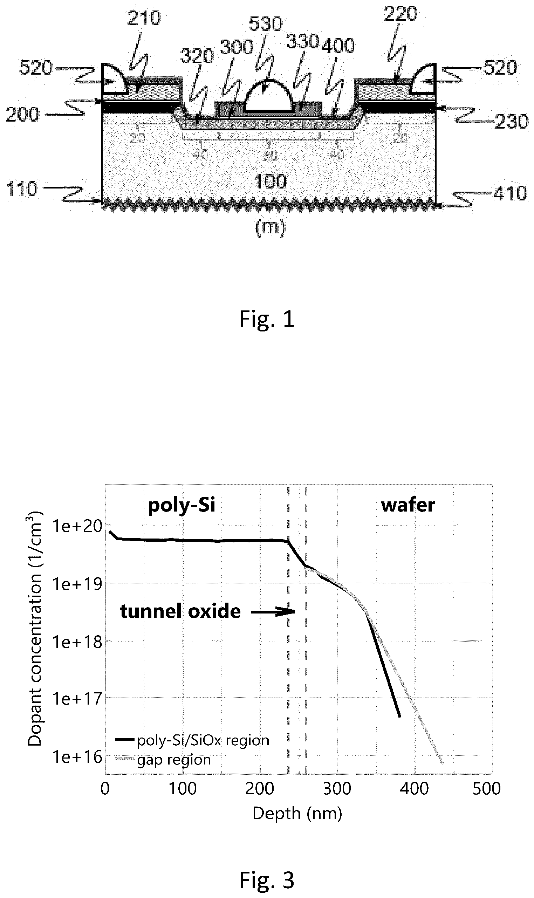

- Fig. 3:: Dotierprofile im Bereich eines Tunnelkontakts mit poly-Si und des benachbarten Gaps mit gleichem Dotierungstyp einer erfindungsgemäßen Solarzelle.

Die Erfindung wird nachfolgend anhand eines bevorzugten Beispiels mit einem n-dotierten Wafer, einer n-dotierten Basis mit Tunnelkontakt, einem p-dotierten Gap und einem p-dotierten Emitter mit Tunnelkontakt erläutert, sie ist aber auch auf anders verteilte Dotierungsarten anwendbar, solange ein dotiertes Gap und ein gleich wie das Gap dotierter Bereich mit einem Tunnelkontakt zueinander benachbart sind.

Figur 1 zeigt eine IBC polyZEBRA Solarzelle 1 mit
- einem n-Typ Silizium Wafer 100,
- einer n-dotierten Basis 20 mit einem Tunnelkontakt, der durch eine Tunneloxidschicht 200 unter einer n-dotierten poly-Si Schicht 210 gebildet wird,
- einem p-dotierten Emitter 30 mit einem Tunnelkontakt, der durch eine Tunneloxidschicht 300 unter einer p-doteriten poly-Si Schicht 310 gebildet wird, und
- mit einem zwischen der n-dotierten Basis 20 und dem p-dotierten Emitter 30 liegenden p-dotierten Gap 40.

In der Darstellung der Figur 1 ist die bei Betrieb der IBC polyZEBRA Solarzelle der Sonne zugewandte Frontseite die Unterseite; dementsprechend ist die der Fronseite gegenüberliegende Rückseite an der Oberseite der Darstellung der Figur 1 zu finden.

Eine Besonderheit der in Figur 1 dargestellten IBC polyZEBRA Solarzelle ist, dass das p-dotierte Gap 40 durch einen Teilbereich eines unterhalb der Tunneloxidschicht 300 verlaufenden Tails 320 der Dotierung des p-dotierten Emitters 30 mit Tunnelkontakt gebildet wird, der sich ausgehend von dem p-dotierten Emitter 30 mit Tunnelkontakt in Richtung auf eine benachbarte n-dotierte Basis 20 mit Tunnelkontakt hin erstreckt. Damit ist auch gewährleistet, dass das Dotierungsprofil des p-dotierten Gaps 40 gleich dem Dotierungsprofil unterhalb der den Tunnelkontakt herstellenden Tunneloxidschicht 300 des zum Gap 40 benachbarten p-dotierten Emitters 30 ist. Der Anschluss der Solarzelle erfolgt mittels der Kontakte 520,530.

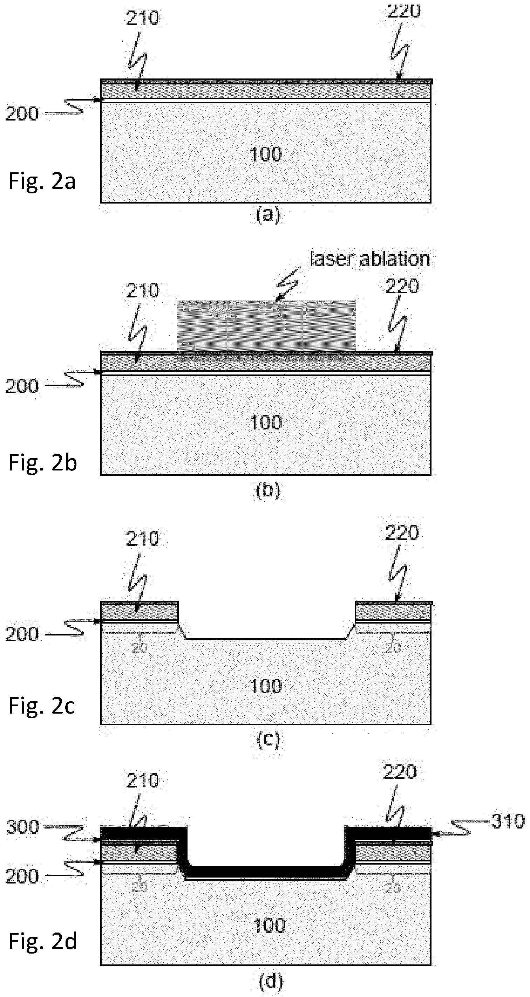

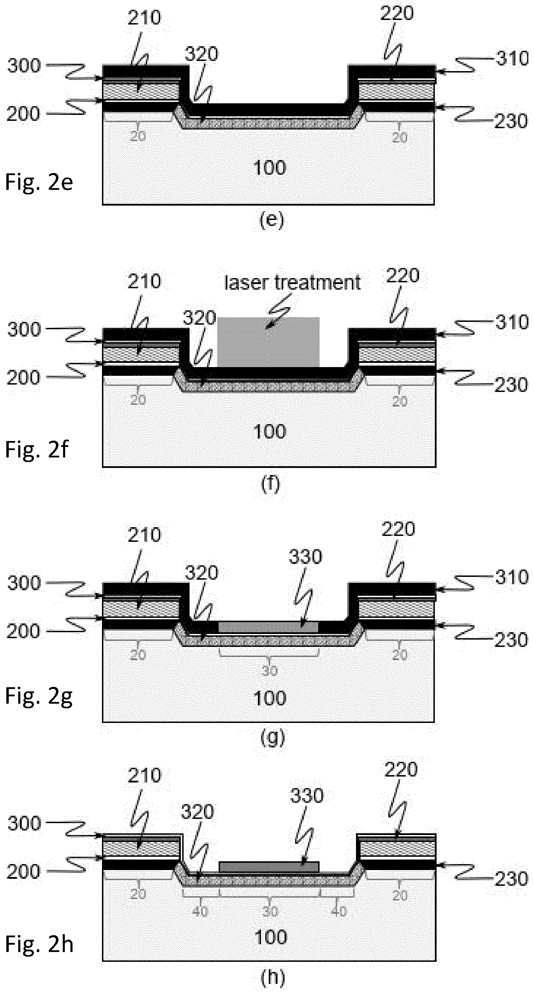

Die Figuren 2a bis 2l zeigen Zwischenstadien bei der Herstellung einer IBC polyZEBRA Solarzelle.

Der Zwischenzustand in Figur 2a kann beispielsweise ausgehend von einem nach dem Czochralski-Verfahren erhaltenen n-Typ Silizium Wafer 100 erhalten werden, indem man nach Entfernung von Sägeschaden und Reinigung auf der Rückseite der Solarzelle eine Tunneloxid-Schicht 200 aufwachsen lässt und darüber eine n+ poly-Si-Schicht 210 aufbringt, ehe auf diese eine Deckschicht 220 aus Siliziumnitrid aufgebracht wird, um den in Figur 2a gezeigten Zwischenzustand zu erreichen.

Die Deckschicht 220 wird danach -beispielsweise wie in Figur 2b dargestellt mittels Laserablation- in den Bereichen des n-Typ Silizium Wafers 100, in denen der Gap 40 bzw. der p-dotierte Emitter 30 erzeugt werden sollen, wieder entfernt, verbleibt aber in den Bereichen der Rückseite, in denen die n-dotierte Basis 20gebildet wird. Anschließend werden in diesen Bereichen der Rückseite die n+ poly-Si-Schicht 210 und die Tunneloxid-Schicht 200 durch Ätzen entfernt, so dass der Zwischenzustand gemäß Figur 2c erreicht wird. In diesem Zustand ist die n-dotierte Basis 20 gebildet.

Nach einem Reinigungsschritt lässt man erneut auf der Rückseite der Solarzelle eine Tunneloxid-Schicht 300 aufwachsen und deponiert darüber eine intrinsische undotierte poly-Si-Schicht 310, so dass der in Figur 2d dargestellte Zwischenzustand entsteht, an dem dann ein p-Dotierungsschritt -in diesem Beispiel ein Bor-Diffusionsprozess- durchgeführt wird, so dass die undotierte poly-Si-Schicht 310 zu einer p+ poly-Si-Schicht wird.

Den Zwischenzustand nach diesem p-Dotierungsschritt zeigt die Figur 2e. Wesentlich für die Erfindung ist, dass in diesem Dotierungsschritt, der in diesem Ausführungsbeispiel als Bor-Diffusion realisiert wird, nicht nur die für die Erzeugung des p-dotierten Emitters 30 benötigte Dotierung erfolgt, sondern auch die Dotierung des Gaps 40. Diese wird insbesondere dadurch erreicht, dass die Dotierung so durchgeführt wird, dass Dotierungsatome, die bis in den Bereich unterhalb der Tunneloxidschicht 300 vordringen, einen p-dotierten "Tail" 320 des Dotierungsprofils bilden. Im gleichen Schritt wird auch ein notwendiger n-dotierter Tail 230 unterhalb der Tunneloxidschicht 200 im Bereich der Basis 20 gebildet. Wenn, wie im gezeigten Ausführungsbeispiel, der Dotierungsschritt als Bor-Diffusion realisiert wird, kann dies dadurch gewährleistet werden, dass die Bor-Diffusion mit einer Depositionsphase und einer Eintreibephase erfolgt.

Ein Beispiel für ein derartiges Dotierungsprofil ist in der Figur 3 dargestellt, wobei die Dotierprofile im Bereich des p-dotierten Emitters 30 und des p-dotierten Gaps 40 nach dem Entfernen der p-poly-Si Schicht 310 miteinander verglichen werden. Man erkennt dabei deutlich den in beiden Fällen innerhalb der erzielten Messgenauigkeit identischen Tail 320 im Bereich unterhalb des Tunneloxids 300, dessen Form durch die für Depositionsphase und Eintreibephase des Bor-Diffusionsprozesses gewählten Prozessparameter beeinflussbar ist.

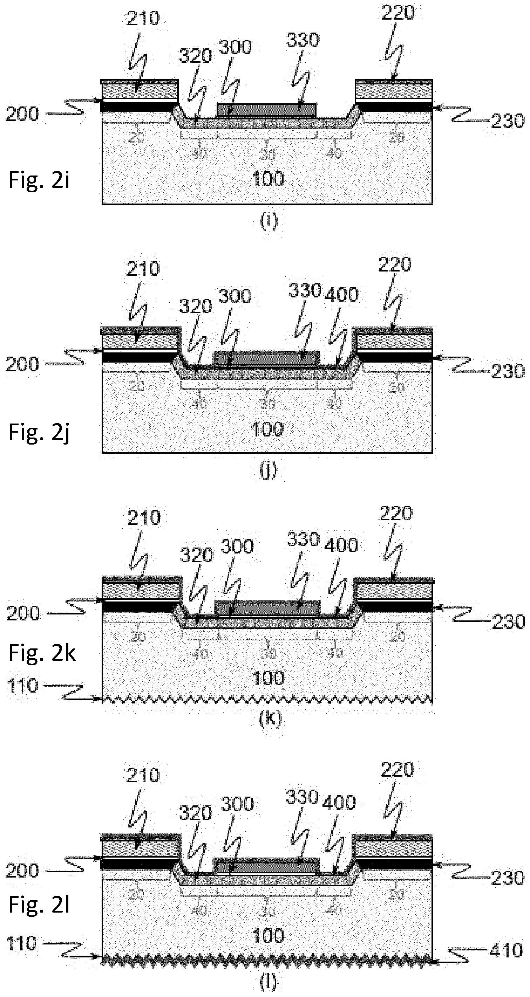

Im Herstellungsprozess der Solarzelle wird als nächstes der Bereich, der den p-dotierten Emitter 30 bildet, durch Bestrahlung mit einem Laser aktiviert, so dass seine Ätzstabilität erhöht wird, wie in Figur 2f gezeigt ist. Dementsprechend sind bei dem darauffolgenden Bearbeitungsschritt, dessen Ergebnis in Figur 2h zu sehen ist und bei dem insbesondere die p-dotierte Poly-Si-Schicht 310 im Bereich des Gaps 40-insbesondere durch alkalisches Ätzen- entfernt wird, sind der dabei durch die aktivierte p-Poly-Si-Schicht gebildete p-dotierte Emitter 30 durch die Laser-Aktivierung und die n-dotierte Basis 20durch die Deckschicht 220 aus Siliziumnitrid geschützt. Vorzugsweise wird ein solcher Ätzprozess so durchgeführt, dass ein Ätzstop am Tunneloxid 300 erfolgt, das dann nachfolgend separat entfernt wird, um die in Figur 2i gezeigte Konfiguration herzustellen. Dies kann außerdem die Homogenität des Rückätzens des p-Poly-Si verbessern. Eine Texturierung der Oberfläche im Bereich des Gaps 40 wird vermieden, wodurch eine Verringerung der Oberflächenrekombination bewirkt werden kann.

Im Gegensatz zu der Oberfläche des Gaps 40 ist eine Texturierung 110 an der Oberfläche der Frontseite der Solarzelle in vielen Fällen erwünscht. Um diese herbeizuführen, kann eine Maske 400 auf die Rückseite aufgebracht werden oder eine Einseiten-Textur vorgenommen werden. Figur 2k zeigt das Resultat einer solchen Texturierung. Die Maskierung der Rückseite kann es auch ermöglichen, eine weitere, frontseitige Dotierung durchzuführen, beispielsweise um durch eine frontseitige n-Dotierung eine Floating Emitter-Struktur zu erzeugen.

Unabhängig davon ob eine rückseitige Schutzschicht, frontseitige Texturierung und/oder weitere Dotierung vorgenommen wird oder nicht, erfolgt anschließend noch eine beidseitige Oberflächenpassivierung durch das Aufbringen einer AlOx / SiNx Schicht 400, 410, was zu der in Figur 2l gezeigten Konfiguration führt und die Metallisierung im Siebdruckverfahren mit Ag oder Ag/Cu, um eine Kontaktierung der Solarzelle mit den Kontakten 520,530 zu erlauben, die in Figur 1 gezeigt sind. Die Passivierungsschicht 400 auf der Rückseite kann auch als Schutzschicht dienen und, wie in Figur 2j gezeigt ist, bereits vor der Texturierung der Vorderseite aufgebracht werden.

### Bezugszeichenliste

- 20: n-dotierte Basis
- 30: p-dotierter Emitter
- 40: p-dotiertes Gap
- 100: Wafer
- 110: Texturierung
- 200,300: Tunneloxidschicht
- 210: n poly-Si-Schicht
- 220: Deckschicht
- 230: n-dotierter Tail der Basis
- 310: i/p poly-Si-Schicht
- 320: p-dotierter Tail des Emitters/Gaps
- 330: aktivierte p poly-Si-Schicht
- 400,410: Oberflächenpassivierungsschicht
- 520,530: Kontakt

## Patentansprüche

1. Interdigitated Back Contact Solarzelle, mit
- einem mit einem ersten Dotierungstyp dotierten Silizium Wafer (100) mit einer Fronseite und einer Rückseite,
- einem auf der Rückseite angeordneten, mit einem zweiten Dotierungstyp dotierten Bereich mit einem Tunnelkontakt, der durch eine Tunneloxidschicht (200,300) gebildet wird,
- einer auf der Rückseite angeordneten, mit dem ersten Dotierungstyp dotierten Bereich mit einem Tunnelkontakt, der durch eine Tunneloxidschicht (200,300) gebildet wird, und
- einem zwischen dem mit einem zweiten Dotierungstyp dotierten Bereich und dem mit dem ersten Dotierungstyp dotierten Bereich liegenden, mit dem zweiten oder ersten Dotierungstyp dotierten Gap (40),
**dadurch gekennzeichnet, dass** das Dotierungsprofil des Gaps (40) gleich dem Dotierungsprofil unterhalb der den Tunnelkontakt bildenden Tunneloxidschicht (200,300) des zum Gap (40) benachbarten mit dem gleichen Dotierungstyp dotierten Bereichs ist.

2. Interdigitated Back Contact Solarzelle nach Anspruch 1,
**dadurch gekennzeichnet, dass** der erste Dotierungstyp eine n-Dotierung und der zweite Dotierungstyp eine p-Dotierung ist, so dass die Interdigitated Back Contact Solarzelle aufweist:
- einen n-Typ Silizium Wafer (100) mit einer Fronseite und einer Rückseite,
- einen auf der Rückseite angeordneten p-dotierten Emitter (30) mit einem Tunnelkontakt, der durch eine Tunneloxidschicht (300) gebildet wird,
- eine auf der Rückseite angeordnete n-dotierte Basis (20) mit einem Tunnelkontakt, der durch eine Tunneloxidschicht (200) gebildet wird, und
- ein zwischen dem p-dotierten Emitter (30) und der n-dotierten Basis (20) liegendes p-dotiertes Gap (40),
wobei das Dotierungsprofil des p-dotierten Gaps (40) gleich dem Dotierungsprofil unterhalb der den Tunnelkontakt bildenden Tunneloxidschicht (300) des zum Gap (40) benachbarten p-dotierten Emitters (30) ist.

3. Interdigitated Back Contact Solarzelle nach Anspruch 2,
**dadurch gekennzeichnet, dass** das p-dotierte Gap (40) durch einen Teilbereich eines unterhalb der den Tunnelkontakt bildenden Tunneloxidschicht (300) des zum Gap (40) benachbarten p-dotierten Emitters (30) verlaufenden Tails (320) gebildet wird, der sich ausgehend von dem p-dotierten Emitter (30) in Richtung auf eine benachbarte n-dotierte Basis (20) mit Tunnelkontakt hin erstreckt.

4. Interdigitated Back Contact Solarzelle nach einem der Ansprüche 1 bis 3,
**dadurch gekennzeichnet, dass** die Oberfläche im Bereich des Gaps (40) glatt und nicht texturiert ist.

5. Verfahren zur Herstellung einer Interdigitated Back Contact Solarzelle nach einem der Ansprüche 1 bis 4, **dadurch gekennzeichnet, dass** die Erzeugung des Dotierprofils des Gaps (40) und des zum Gap (40) benachbarten mit dem gleichen Dotierungstyp dotierten Bereichs mit denselben Prozessschritten, die gemeinsam durchgeführt werden, erfolgt.

6. Verfahren nach Anspruch 5,
**dadurch gekennzeichnet, dass** die Erzeugung des Dotierprofils des Gaps (40) und des zum Gap (40) benachbarten mit dem gleichen Dotierungstyp dotierten Bereichs (30) in demselben Hochtemperaturschritt erfolgt.

7. Verfahren nach Anspruch 6,
**dadurch gekennzeichnet, dass** während des Hochtemperaturschritts Dotanten aus einer p-dotierten Poly-Si_Schicht (310) durch das darunter liegende Tunneloxid (300) in den n-Typ Wafer eingetrieben werden.

8. Verfahren nach Anspruch 6,
**dadurch gekennzeichnet, dass** die Dotierung einer zuvor undotierten Poly-Si-Schicht (310) und der Hochtemperaturschritt zum Eintreiben von Dotanten aus der poly-Si-Schicht (310) durch das Tunneloxid (300) in den n-Typ Wafer in einem Diffusionsschritt kombiniert werden.

9. Verfahren nach einem der Ansprüche 6 bis 8,
**dadurch gekennzeichnet, dass** der Hochtemperaturschritt der einzige Hochtemperaturschritt bei der Herstellung der Interdigitated Back Contact Solarzelle ist.

10. Verfahren nach einem der Ansprüche 5 bis 9,
**dadurch gekennzeichnet, dass** während der gemeinsam erfolgenden Erzeugung des Dotierprofils eines p-dotierten Emitters (30) mit Tunnelkontakt und eines p-dotierten Gaps (40) die Tunneloxidschicht (300) und eine Poly-Si-Schicht (310), die zur Herstellung des p-dotierten Emitters (30) mit Tunnelkontakt p-dotiert wird, den Bereich, in dem das p-dotierte Gap (40) erzeugt wird mit überdecken und dass nach der gemeinsam erfolgenden Dotierung des p-dotierten Emitters (30) mit Tunnelkontakt und des p-dotierten Gaps (40) diese Schichten im Bereich des p-dotierten Gaps (40) entfernt werden.

11. Verfahren nach Anspruch 10,
**dadurch gekennzeichnet, dass**
die Tunneloxidschicht (300) und die Poly-Si-Schicht (310), die zur Herstellung des p-dotierten Emitters (30) mit Tunnelkontakt p-dotiert wird, nach der gemeinsam erfolgenden Dotierung des p-dotierten Emitters (30) mit Tunnelkontakt und des p-dotierten Gaps (40) im Bereich des p-dotierten Gaps (40) in zwei separat voneinander verlaufenden Prozessschritten entfernt werden.

12. Verfahren nach Anspruch 10 oder 11,
**dadurch gekennzeichnet, dass** nach der gemeinsam erfolgenden Dotierung des p-dotierten Emitters (30) mit Tunnelkontakt und des p-dotierten Gaps (40) die p-dotierte Poly-Si-Schicht (310) im Bereich des p-dotierten Emitters (30) mit Tunnelkontakt durch Bestrahlung mit einem Laser aktiviert wird, so dass sie ätzstabil wird, und danach im Bereich des p-dotierten Gaps (40) zurückgeätzt wird.

13. Verfahren nach Anspruch 12,
**dadurch gekennzeichnet, dass** das Zurückätzen im Bereich des p-dotierten Gaps (40) mit einer alkalischen Ätzlösung erfolgt, deren Ätzrate für p-dotiertes Poly-Si höher ist als für das Tunneloxid.

14. Verfahren nach Anspruch 12,
**dadurch gekennzeichnet, dass** das Zurückätzen im Bereich des p-dotierten Gaps (40) durch atmospheric dry etching erfolgt.

15. Verfahren nach einem der Ansprüche 5 bis 14,
**dadurch gekennzeichnet, dass** in einem erst nach der Dotierung des p-dotierten Emitters (30) mit Tunnelkontakt durchgeführten Verfahrensschritt eine Schutzschicht (400) auf die Rückseite aufgebracht wird.

16. Verfahren nach Anspruch 15,
**dadurch gekennzeichnet, dass** nach dem Aufbringen der Schutzschicht (400) auf die Rückseite die Frontseite texturiert (110) wird.

17. Verfahren nach Anspruch 15 oder 16,
**dadurch gekennzeichnet, dass** nach dem Aufbringen der Schutzschicht (400) auf die Rückseite die Frontseite n-dotiert oder p-dotiert wird, so dass ein Front Surface Field oder Floating Emitter gebildet wird.
